Europäisches Patentamt

European Patent Office

Office européen des brevets

(19)

(11) Veröffentlichungsnummer. **0 043 989**
**B1**

(12) # EUROPÄISCHE PATENTSCHRIFT

(45) Veröffentlichungstag der Patentschrift:
31.10.84

(21) Anmeldenummer: 81105114.3

(22) Anmeldetag: 01.07.81

(51) Int. Cl.³: **B 44 C 1/14**

(54) **Verfahren zur Herstellung einer Verbundfolie.**

(30) Priorität: 10.07.80 DE 3026236

(43) Veröffentlichungstag der Anmeldung:
20.01.82 Patentblatt 82/3

(45) Bekanntmachung des Hinweises auf die Patenterteilung:
31.10.84 Patentblatt 84/44

(84) Benannte Vertragsstaaten:
AT BE CH DE FR GB IT LI LU NL SE

(56) Entgegenhaltungen:
CH - A - 356 051
DE - A - 2 222 144
DE - A - 2 401 813
DE - A - 2 856 510
FR - A - 1 351 287
FR - A - 1 591 695
GB - A - 1 445 172
US - A - 3 463 651
US - A - 4 012 552
US - A - 4 242 378

(73) Patentinhaber: Interletter AG, Hochstrasse 28,
CH-8044 Zürich (CH)

(72) Erfinder: Czichy, Eleonore, Schwangaustrasse 26,
D-8900 Augsburg (DE)

(74) Vertreter: Weickmann, Heinrich, Dipl.-Ing. et al,
Patentanwälte Dipl.-Ing. H.Weickmann Dipl.-Phys.Dr.
K.Fincke Dipl.-Ing. F.A.Weickmann Dipl.-Chem. B. Huber
Dr.-Ing. H. Liska Dipl.-Phys.Dr. J. Prechtel
Postfach 860820, D-8000 München 86 (DE)

## Beschreibung

Die Erfindung betrifft ein Verfahren zur Herstellung einer Verbundfolie nach dem Oberbegriff des Anspruchs 1.

Bei einem nach der FR-PS 1 591 695 bekannten Verfahren dieser Art liegen im Ergebnis die die Form der Bildstruktur aufweisenden Bereiche der lösungsmittelresistenten Schicht und der auf diesen verbleibenden Bereiche der Metallschicht zwischen einer Unterlagsfolie und einer Deckfolie. Je nachdem, ob man die Unterlagsfolie oder die Deckfolie abzieht, blickt man auf die lösungsmittelresistenten Bereiche (die dann freiliegen) oder die Metallbereiche (die dann freiliegen).

Nach der DE-OS 2 222 144 ist ein spezielles Verfahren gemäß dem sog. Heißvergoldungsprozeß bekannt, bei dem mittels einer Matrize von einer provisorischen Trägerschicht, auf der sich ein antihaftend wirkender, übertragbarer Überzug mit Lackschicht und darauf eine Metallschicht befindet, durch Heißpressen der Matrize entsprechende Bereiche der Metallschicht und der Lackschicht abgehoben und auf eine Trägerunterlage aufgebracht werden können. Der Betrachter sieht dann durch die Lackschicht auf die freiliegenden, übertragenen Metallbereiche.

Aufgabe der Erfindung ist es, ein Verfahren zur Herstellung einer Verbundfolie nach dem Oberbegriff des Anspruchs 1 anzugeben, das besonders wirtschaftlich für kleine Auflagen benutzt werden kann, dem Betrachter aber nicht die freiliegenden Metallbereiche darbietet, sondern mit transparentem Lack überzogene Metallbereiche, so daß eine besondere Glanzwirkung auftritt.

Die Lösung dieser Aufgabe ist im Kennzeichen des Anspruchs 1 angegeben.

Das erfindungsgemäße Verfahren führt dazu, daß die Verbundfolie mit ihrer rückwärtigen Klebstoffschicht auf eine beliebige Unterlage aufgeklebt werden kann. Ist die Trägerschicht durchsichtig, so braucht sie nicht entfernt zu werden, gleich wenn sie entfernt werden kann. Jedenfalls blickt der Betrachter auf die stehengebliebenen Bereiche der Metallschicht durch die Lackschicht, was den Glanz der stehengebliebenen Bereiche der Metallschicht erhöht.

Vorteilhafte Ausgestaltungen der Erfindung sind in den Unteransprüchen angegeben.

Die Erfindung wird im folgenden an einem Ausführungsbeispiel unter Hinweis auf die Zeichnungen erläutert.

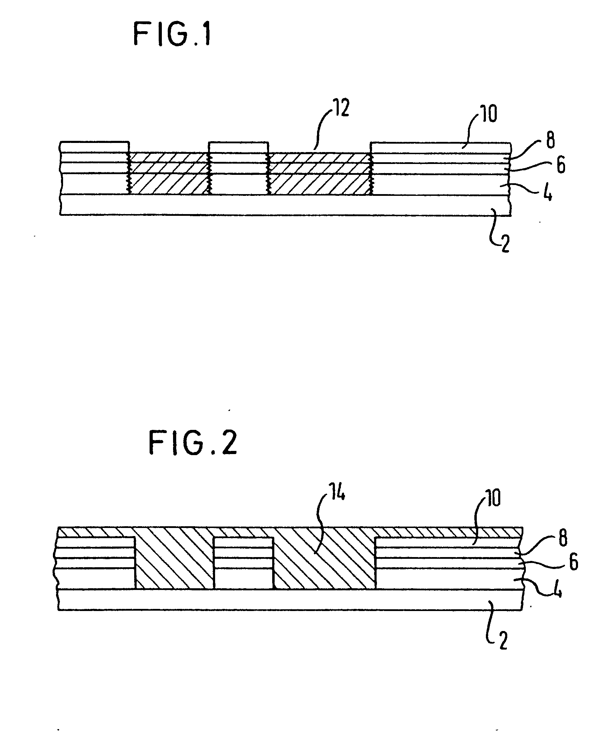

Fig. 1 zeigt eine Verbundfolie in den ersten Phasen ihrer Herstellung im Querschnitt;

Fig. 2 zeigt die fertige Verbundfolie im Querschnitt.

Auf eine Polyesterfolie 2 ist zunächst durchgehend eine Schicht 4 aus einem Lack aufgebracht, von dem die Folie 2 kalt abzuziehen ist. Bei einer Folie 2 aus Polyester hat sich ein Vinyllack bewährt, der in einem Gemisch aus Azeton und Butanon-2 gelöst war. Auf die Schicht 4 wurde eine durchgehende, ebenso wie die Schicht 4 transparente, aber farblich getönte Schicht 6 aufgebracht, etwa ein pigmentierter Lack auf Vinylchlorid/Vinylacetat-Basis. Ist keine Tönung erwünscht, kann die Schicht 6 entfallen. Die Schicht 6 kann auch entfallen, wenn die Schicht 4 getönt wird. Auf die durchgehende Schicht 6 wurde eine durchgehende Metallschicht 8, etwa aus Aluminium aufgebracht, etwa durch Aufdampfen. Auch eine solche Metallschicht kann mit farbgebenden Zusätzen versehen sein.

Auf die durchgehende Schicht 8 wurde mittels Druckfarbe oder mittels licht-gehärteter Emulsion eine Bildstruktur 10 aufgebracht. Die Bildstruktur 10 ließ somit Bereiche 12 frei. In diesen Bereichen 12 konnte die Aluminiumschicht mit einem geeigneten Lösungsmittel, etwa Natronlauge, entfernt werden. Zum Stoppen des Lösungsvorgangs und zum Neutralisieren der Natronlauge kann 5%ige Essigessenz verwendet werden. Anschließend können die Schichtbereiche 6 und 4 durch geeignete Lösungsmittel entfernt werden. Ist dies geschehen, so wird die Bildstruktur mit einem Haftkleber 14 beschichtet. (In den Figuren sind die Dickenverhältnisse selbstverständlich nicht maßstabgerecht dargestellt, sondern so, daß der Schichtaufbau klar wird.)

## Patentansprüche

1. Verfahren zur Herstellung einer Verbundfolie, bei dem auf eine Trägerschicht (2) eine Metallschicht (8) und darauf eine in die Form der Bildstruktur aufweisende Bereiche unterteilte lösungsmittelresistente Schicht (10) aufgebracht wird und bei dem mittels wenigstens eines Lösungsmittels das Metall der Metallschicht (8) zwischen den Bereichen entfernt wird, dadurch gekennzeichnet, daß auf die Trägerschicht (2) vor dem Aufbringen der Metallschicht (8) eine durchgehende Lackschicht (4) aufgebracht wird, daß mittels des wenigstens einen Lösungsmittels auch der Lack dieser Lackschicht (4) zwischen den Bereichen entfernt wird und daß auf die Bereiche der lösungsmittelresistenten Schicht (10) und die freigelegten Bereiche der Trägerschicht (2) eine Klebstoffschicht (14) aufgebracht wird.

2. Verfahren nach Anspruch 1, dadurch gekennzeichnet, daß auf die durchgehende Lackschicht (4) vor dem Aufbringen der Metallschicht (8) eine durchgehende, farblich getönte Schicht (6) aufgebracht und ebenso behandelt wird wie die durchgehende Lackschicht (4).

3. Verfahren nach einem der vorgenannten Ansprüche, dadurch gekennzeichnet, daß die lösungsmittelresistente Schicht (10) aus einer belichteten fotografischen Emulsion oder einer Druckfarbe auf Polyamid-Basis gebildet wird.

4. Verfahren nach einem der vorgenannten Ansprüche, dadurch gekennzeichnet, daß die mit dem Lösungsmittel zu behandelnde Fläche vor der Behandlung — vorzugsweise mit Talkum — bepudert wird.

5. Verfahren nach einem der vorgenannten Ansprüche, dadurch gekennzeichnet, daß als Lösungsmittel für eine aus Aluminium bestehende Metallschicht Natronlauge verwendet wird.

6. Verfahren nach einem der vorgenannten Ansprüche, dadurch gekennzeichnet, daß als Trägerschicht (2) eine Polyesterfolie verwendet wird.

7. Verfahren nach einem der vorgenannten Ansprüche, dadurch gekennzeichnet, daß die durchgehende Lackschicht (4) aus Vinyllack gebildet wird.

8. Verfahren nach einem der Ansprüche 2 bis 7, dadurch gekennzeichnet, daß als Tönungsmittel für die farblich getönte Schicht (6) ein Fettfarbstoff, ein spirituslöslicher Farbstoff oder ein anorganisches Pigment verwendet wird.

9. Verfahren nach einem der Ansprüche 2 bis 8, dadurch gekennzeichnet, daß als Basismaterial der farblich getönten Schicht (6) ein Vinylchlorid-Vinylacetat-Co-Polymer verwendet wird.

10. Verfahren nach einem der vorgenannten Ansprüche, dadurch gekennzeichnet, daß die Metallschicht (8) aus Aluminium, Kupfer, Silber oder Chrom gebildet wird.

11. Verfahren nach einem der vorgenannten Ansprüche, dadurch gekennzeichnet, daß die Metallschicht (8) auf die Lackschicht (4) bzw. die farblich getönte Schicht (6) aufgedampft wird.

12. Fahren nach einem der vorgenannten Ansprüche, dadurch gekennzeichnet, daß die Klebstoffschicht (14) aus einem Haftklebstoff gebildet wird.

## Claims

1. Method for the production of a composite foil in which a metal layer (8) is applied upon a carrier layer (2) and a solvent-resistant layer (10) divided into zones having the form of the image structure is applied thereupon and in which the metal of the metal layer (8) is removed between the zones by means of at least one solvent, characterised in that a continuous lacquer layer (4) is applied to the carrier layer (2) before the application of the metal layer (8), in that the lacquer of this lacquer layer (4) is also removed between the zones by means of the at least one solvent and in that an adhesive coating (14) is applied upon the zones of the solvent- resistant layer (10) and the exposed zones of the carrier layer (2).

2. Method according to claim 1, characterised in that an uninterrupted, colour-toned layer (6) is applied upon the continuous lacquer layer (4) before the application of the metal layer (8) and is treated just like the continuous lacquer layer (4).

3. Method according to one of the above claims, characterised in that the solvent-resistant layer (10) is formed from an exposed photographic emulsion or a printing ink on a polyamide basis.

4. Method according to one of the above claims, characterised in that the surface to be treated with the solvent is powdered before the treatment — preferably with talcum.

5. Method according to one of the above claims, characterised in that caustic soda is used as solvent for a metal layer consisting of aluminium.

6. Method according to one of the above claims, characterised in that a polyester foil is used as carrier layer (2).

7. Method according to one of the above claims, characterised in that the continuous lacquer layer (4) is formed from vinyl lacquer.

8. Method according to one of claims 2 to 7, characterised in that as toning medium for the colourtoned layer (6) there is used a fat dyestuff, a spirit-soluble dyestuff or an inorganic pigment.

9. Method according to one of claims 2 to 8, characterised in that a vinyl chloride — vinyl acetate copolymer is used as basic material for the colour-toned layer (6).

10. Method according to one of the above claims, characterised in that the metal layer (8) is formed from aluminium, copper, silver or chromium.

11. Method according to one of the above claims, characterised in that the metal layer (8) is applied by vaporisation upon the lacquer layer (4) or the colour-toned layer (6) as the case may be.

12. Method according to one of the above claims, characterised in that the adhesive coating (14) is formed from a contact adhesive.

## Revendications

1. Procédé pour la fabrication d'une feuille stratifiée, dans lequel sont déposées sur une couche de support (2) une couche métallique (8) et, sur cette dernière, une couche (10) résistant aux solvants et subdivisée en des zones présentant la forme de la structure d'image, et dans lequel le métal de la couche métallique (8) est éliminé entre les zones à l'aide d'au moins un solvant, caractérisé par le fait qu'une couche ininterrompue de vernis (4) est déposée sur la couche de support (2) avant la mise en place de la couche métallique (8); par le fait que le vernis de cette couche de vernis (4) est également éliminé entre les zones au moyen du solvant précité prévu au minimum; et par le fait qu'une couche d'adhésif (14) est déposée sur les zones de la couche (10) résistant aux solvants et sur les zones dégagées de la couche de support (2).

2. Procédé selon la revendication 1, caractérisé par le fait que, avant la mise en place de la couche métallique (8), une couche ininterrompue (6) à nuance colorée est appliquée sur la couche ininterrompue de vernis (4) et est traitée de la même manière que cette couche ininterrompue de vernis (4).

3. Procédé selon l'une des revendications précédentes, caractérisé par le fait que la couche (10) résistant aux solvants consiste en une émulsion photographique exposée ou en une encre d'imprimerie sur une base de polyamide.

4. Procédé selon l'une des revendications précédentes, caractérisé par le fait que la surface devant être traitée à l'aide du solvant est saupoudrée avant son traitement, de préférence avec du talc.

5. Procédé selon l'une des revendications précédentes, caractérisé par le fait que, pour une couche métallique consistant en de l'aluminium, on utilise de la soude en guise de solvant.

6. Procédé selon l'une des revendications précédentes, caractérisé par le fait qu'on utilise une feuille de polyester en guise de couche de support (2).

7. Procédé selon l'une des revendications précédentes caractérisé par le fait que la couche ininterrompue de vernis (4) est constituée par un vernis vinylique.

8. Procédé selon l'une des revendications 2 à 7, caractérisé par le fait que, en guise de colorant pour la couche (6) à nuance colorée, on utilise un colorant gras, un colorant soluble dans l'alcool, ou un pigment anorganique.

9. Procédé selon l'une des revendications 2 à 8, caractérisé par le fait qu'on utilise, en guise de matière de base de la couche (6) à nuance colorée, un copolymère de chlorure de vinyle et d'acétate de vinyle.

10. Procédé selon l'une des revendications précédentes, caractérisé par le fait que la couche métallique (8) est formée par de l'aluminium, du cuivre, de l'argent ou du chrome.

11. Procédé selon l'une des revendications précédentes, caractérisé par le fait que la couche métallique (8) est métallisée sous vide sur la couche de vernis (4) ou sur la couche (6) à nuance colorée, respectivement.

12. Procédé selon une des revendications précédentes, caractérisé par le fait que la couche d'adhésif (14) est constituée par une masse auto-adhésive.

# FIG.1

# FIG.2